# EUROPEAN PATENT SPECIFICATION

(11) **EP 4 356 696 B1**
(45) Date of publication and mention of the grant of the patent: **21.10.2026**
(21) Application number: 22737370.1
(22) Date of filing: 14.06.2022
(51) Int. Cl.: H05K 5/03, H05K 5/06, H05K 7/14, H05K 7/20

(54) **SUBSEA ELECTRONICS ASSEMBLY AND SUBSEA ELECTRONICS MODULE**
UNTERWASSERELEKTRONIKANORDNUNG UND UNTERWASSERELEKTRONIKMODUL
ENSEMBLE ÉLECTRONIQUE SOUS-MARIN ET MODULE ÉLECTRONIQUE SOUS-MARIN

(30) Priority: 14.06.2021 GB 202108441
(43) Date of publication of application: 24.04.2024
(73) Proprietor: Aker Solutions Subsea AS, 1366 Lysaker (NO)
(72) Inventor: LÅG, Ørjan, 0452 Oslo (NO); MOEN, Stig, 1358 Jar (NO)
(74) Representative: HGF
(86) International application number: PCT/EP2022/066244
(87) International publication number: WO 2022/263480

(56) References cited:
- WO-A1-2017/086974
- CN-B- 103 929 928
- US-A- 6 118 662
- US-A1- 2017 170 640

## Description

This invention relates to a subsea electronics assembly, and a subsea electronics module comprising the subsea electronics assembly; and associated methods.

### BACKGROUND

A subsea electronics apparatus may be for use in subsea oil and gas equipment, such as a part of a subsea well, or for use in a subsea energy installation such as for a wind turbine or tidal generator. A subsea electronics module houses electronics components for control, power supply, power distribution, or other functions. The electronics components are typically provided in a housing to protect them from the environmental conditions, in particular sea water (may be at high pressure due to subsea conditions) and contaminants. A subsea electronics module typically includes electronics components that are assembled on a chassis, and the chassis is inserted within a sealed housing.

Some electronic components can generate heat which should be dissipated away from the electronics components to prevent overheating and malfunction. It is known to dissipate the heat from the electronics components by thermal transfer from the electronics components to the chassis and onwards to the housing of the electronic device, which itself may be exposed to seawater on an outer side allowing heat dissipation into the local environment.

The Applicant's co-pending patent application GB2583711, discloses a subsea electronic apparatus that includes a housing, a chassis for insertion into the housing, and at least one electronic component mounted to the chassis. The apparatus also includes a heat transfer portion that is in contact with the electronic component and configured to move relative to the chassis to contact the housing on insertion of the chassis into the housing. Accordingly, the heat transfer portion provides a thermal conduction pathway between the electronic component and the housing. A subsea electronics assembly according to the prior art is disclosed in document US 2017/170640 A1.

### BRIEF SUMMARY OF THE DISCLOSURE

In accordance with the present disclosure there is provided a subsea electronics assembly, such as for mounting in a cavity of a housing. The subsea electronics assembly may comprise a chassis and an electronics sub-assembly. The electronics sub-assembly may have an electronic component and a heat transfer portion. The electronics sub-assembly may be movably mounted to the chassis. The electronics sub-assembly may be movably mounted to the chassis such that it is movable from a retracted position for insertion of the subsea electronics assembly into the cavity of the housing. The electronics sub-assembly may be movably mounted to the chassis such that it is movable to an expanded position. The expanded position may be where the electronics sub-assembly is moved away from the chassis such that the heat transfer portion contacts a surface of the cavity during use. One or more first biasing members are arranged to bias the electronics assembly towards the retracted position. The electronics sub-assembly may be movably mounted to the chassis such that it is movable between a retracted position for insertion of the subsea electronics assembly into the cavity of the housing, and an expanded position where the electronics sub-assembly is moved away from the chassis such that the heat transfer portion contacts a surface of the cavity during use.

When the electronics sub-assembly, in particular the heat transfer portion, is in contact with the housing then heat generated by the electronic component is conducted to the housing and subsequently to the local environment of the housing. Moving the electronics sub-assembly itself into contact with the housing, rather than only a thermal bridging component, creates a short and efficient thermal transfer path and helps to maintain an appropriate working temperature within the housing.

In examples, the subsea electronics assembly is used in subsea oil and gas equipment, such as a part of a subsea well. In other examples, the subsea electronics assembly is used in a subsea energy installation such as for a wind turbine or tidal generator.

In examples, the electronics sub-assembly is in contact with the chassis when the electronics sub-assembly is in the retracted position. In examples, the electronics sub-assembly is spaced from the chassis when the electronics sub-assembly is in the expanded position. In examples, movement of the electronics sub-assembly from the retracted position to the expanded position increases a spacing between the chassis and the electronics sub-assembly.

In examples, the electronic component is mounted directly to the heat transfer portion. For example, the electronic component may be pressed onto the heat transfer portion, fastened to the heat transfer portion, or attached to the heat transfer portion by a thermal adhesive or thermal paste.

In examples, the electronic component of the electronics sub-assembly comprises a hot component. In particular, the electronic component of the electronics sub-assembly may comprise an electronic component that generates heat during use. Examples of such hot components include a transformer, a capacitor, and/or a battery.

In examples, the heat transfer portion may comprise a heatsink. The heatsink may comprise a metal, for example aluminium or copper.

The hot component/s may be mounted to a printed circuit board (PCB). The electronics sub-assembly may comprise a pair of units. Each of the pair of units may comprise a PCB. The board of each PCB may be identical. The PCB may comprise different components, but comprise a same shape and/or routing pattern. Each unit may comprise a power supply unit (PSU). One of the units may comprise a low voltage PSU. One of the units may comprise a high voltage PSU. The electronics sub-assembly may comprise a power supply unit (PSU). The electronics sub-assembly may comprise at least a pair of PSUs. In at least some examples, the pair of PSUs may comprise a relative low voltage PSU and a relative high voltage PSU respectively.

In examples, the heat transfer portion may be shaped to substantially conform to an internal surface of the cavity of the housing. In particular, a surface of the heat transfer portion may be shaped, for example concave or inclined, to substantially match the corresponding surface of the cavity that will be contacted by the heat transfer portion. In examples, the heat transfer portion may comprise one or more heat transfer pads. The one or more heat transfer pads may comprise a conformable thermally conductive material to improve surface contact between the heat transfer portion and the housing.

In examples, the electronics sub-assembly may be mounted to the chassis on one or more guides arranged to guide the movement of the electronics sub-assembly relative to the chassis. In examples, the one or more guides may be linear guides, for example shafts, sliders, or fasteners, arranged to guide the electronics sub-assembly in a linear direction relative to the chassis.

In examples, the electronics sub-assembly may be movable relative to the chassis in two translational degrees of freedom. In particular, the electronics sub-assembly may be movable relative to the chassis in only two translational degrees of freedom. Specifically, the one or more guides may be arranged to permit movement of electronics sub-assembly relative to the chassis in two translational degrees of freedom relative, and to prevent movement of the electronics sub-assembly in the third translational degree of freedom and to prevent rotation of the electronics sub-assembly relative to the chassis.

In examples, movement of the electronics sub-assembly from the retracted position to the extended position comprises movement of the electronics sub-assembly in at least one of the two translational degrees of freedom.

In examples, the housing is elongate and defines an axial direction and a radial direction. In this example, the two translational degrees of freedom are: (i) in the axial direction, and (ii) in a radial direction. In examples, movement of the electronics sub-assembly between the retracted position and the expanded position is in the radial direction.

The one or more first biasing members are arranged to bias the electronics sub-assembly in the radial direction, towards the chassis. Accordingly, the one or more first biasing members hold the electronics sub-assembly in the retracted position for insertion of the subsea electronics assembly into the housing.

In examples, the subsea electronics assembly may further comprise one or more second biasing members arranged to act on the electronics sub-assembly in a direction substantially perpendicular to the one or more first biasing members. In particular, the one or more second biasing members may be arranged to bias the electronics sub-assembly in the axial direction. The one or more second biasing members may be arranged to bias the electronics sub-assembly towards an intermediate position within the axial translational degree of freedom.

In examples, the subsea electronics assembly may further comprise an actuator configured to move the electronics sub-assembly relative to the chassis.

In examples where the subsea electronics assembly comprises a biasing member adapted to bias the electronics sub-assembly towards the retracted position, the actuator may be operable to move the electronics sub-assembly from the retracted position to the expanded position. That is, the actuator overcomes the biasing force of the biasing member to move the electronics sub-assembly to the expanded position.

In examples, the actuator may comprise a pushing member having an inclined surface adapted to engage the electronics sub-assembly to push the electronics sub-assembly away from the chassis and into the expanded position.

The actuator may comprise a plurality of inclined surfaces. In at least some examples, the plurality of inclined surfaces comprises at least one pair of inclined surfaces associated with a chassis of the electronics sub-assembly. Each of the pair of inclined surfaces may be located at or towards an opposite end portion of the electronics sub-assembly; such as at or towards an opposite end portion of the chassis associated with the electronics sub-assembly. The inclined surface may comprise a wedge. The inclined surface may be configured to function as a cam. The respective inclined surfaces of the pair may comprise a similar angle of inclination. The inclined surface may be linearly inclined, such as with a constant, fixed angle of inclination relative to the longitudinal axis. The pair of inclined surfaces may comprise an identical inclination, oriented in an identical direction. Alternatively, the pair of inclined surfaces may comprise an identical inclination, but oriented in opposite directions - for example, facing towards each other from respective ends of the electronics sub-assembly/chassis. The pair of inclined surfaces may be configured to extend the heat sinks out evenly.

The electronics sub-assembly may be flexibly mounted to the electronics unit. The electronics unit may be associated with a plate, such as an end plate, for engaging the housing opening (e.g. to seal the subsea electronics assembly within the housing). The chassis of the electronics sub-assembly may be mechanically connected to the electronics unit via a flexible coupling, such as comprising one or more spring members. Accordingly there may be provided a degree of flexibility between the electronics unit (e.g. associated with the end plate) and the electronics sub-assembly. The respective central longitudinal axis of each electronics unit (e.g. associated with the end plate) and the electronics sub-assembly may be configured to allow deviation, particularly angularly, with respect to each other. The chassis associated with the electronics sub-assembly may be considered as a distinct chassis from that of the electronics unit. The electronics sub-assembly may be flexibly mounted relative to the end plate. The electronics sub-assembly may be configured to align with the cavity, such as by deviating from a central longitudinal axis of the electronics unit and/or end plate.

The electronics sub-assembly may comprise a stopper for axially contacting a portion of the housing, such as a closed end portion, distal from an open end portion in or through which the electronics sub-assembly may have been inserted. The electronics sub-assembly may be configured such that when the stopper at the front end of the power supply unit contacts the closed end of the housing, the stopper engages the inclined portion/surface such that there is only a pure lateral movement instigated by the inclined portion/surface acting as a cam. Accordingly, an exertion of pressure on soft pads on the outside of the heat sinks may be avoided or mitigated.

In examples, the actuator may be slidably mounted to the chassis. The actuator may be slidably mounted to an end of the chassis.

In examples, the actuator may be actuatable from an end of the chassis. In particular, a screw or other linear actuator may be provided to slide the actuator relative to the chassis to engage and move the electronics sub-assembly.

In examples, the actuator is arranged such that on insertion of the subsea electronics assembly into the cavity the actuator engages a surface of the cavity and the pushing member is moved relative to the chassis to move the electronics sub-assembly towards the expanded position.

In particular, the actuator may be arranged to abut an end surface of the cavity such that further movement of the subsea electronics assembly into the cavity causes the actuator to slide relative to the chassis and the electronics sub-assembly, and to move the electronics sub-assembly towards the expanded position.

In examples, the pushing member comprises a spring-loaded pin protruding from the pushing member and arranged to engage the surface of the cavity. The spring-loaded pin accommodates tolerances and ensures that the heat transfer portion is maintained in contact with the cavity when in the expanded position during use.

In examples, the chassis may comprise a second pushing member having an inclined surface arrange oppositely to the inclined surface of the pushing member and disposed on an opposite side of the electronics sub-assembly. In such an example the electronics sub-assembly may be movable in an axial direction and in a radial direction, and the pushing member and second pushing member act to simultaneously push the electronics sub-assembly towards the expanded position as the pushing member moves axially towards the second pushing member.

In examples, the subsea electronics assembly may comprise a second electronics sub-assembly movably mounted to the chassis and movable between a retracted position for insertion of the subsea electronics assembly into the cavity of the housing, and an expanded position where the second electronics sub-assembly is moved away from the chassis for contacting a surface of the cavity of the housing during use.

In such examples, the second electronics sub-assembly is mounted to an opposite side of the chassis to the electronics sub-assembly. In such an example the electronics sub-assembly and second electronics sub-assembly are pressed against opposite surfaces of the cavity in the expanded position.

In examples with a second electronics sub-assembly the actuator may be adapted to move both of the electronics sub-assembly and the second electronics sub-assembly from the retracted position to the expanded position simultaneously.

In examples, the electronic components on the electronics sub-assembly may comprise a plate adapted to engage the housing and seal the cavity.

In accordance with the present disclosure there is also provided a subsea electronics module comprising the subsea electronics assembly described above and a housing having a cavity adapted to receive the subsea electronics assembly.

In examples, the subsea electronics module is used in subsea oil and gas equipment, such as a part of a subsea well. In other examples, the subsea electronics module is used in a subsea energy installation such as for a wind turbine or tidal generator. It will be appreciated that the subsea electronics module may be used in any subsea application where electronics components need to be provided in a housing to protected against environment conditions.

In examples, the housing is elongate and the cavity comprises a side wall, a closed end, and an open end. In the expanded position the electronics sub-assembly may be in contact with the side wall. Accordingly, in the retracted position the subsea electronics assembly can be moved into the cavity of the housing and then the electronics sub-assembly is moved to the expanded position where it contacts the side wall of the housing.

In examples, the housing may comprise an actuator configured to move the electronics sub-assembly into the expanded position on insertion of the subsea electronics assembly into the cavity. In particular, the actuator may comprise a pushing member having an inclined surface adapted to push the electronics sub-assembly away from the chassis and towards the expanded position as the subsea electronics assembly is inserted into the cavity. In examples, the actuator may be mounted to the closed end of the cavity and arranged to engage the subsea electronics assembly during insertion of the subsea electronics assembly into the cavity.

There is also provided a method of mounting a subsea electronics assembly, such as the subsea electronics assembly of any example, embodiment, aspect or claim herein. The method may comprise mounting the subsea electronics assembly in a cavity of a housing. The subsea electronics assembly may comprise a chassis and an electronics sub-assembly. The electronics sub-assembly may have an electronic component and a heat transfer portion. The method may comprise mounting the electronics sub-assembly movably to the chassis. The method may comprise movably mounting the electronics sub-assembly to the chassis such that it is movable from a retracted position for insertion of the subsea electronics assembly into the cavity of the housing. The method may comprise movably mounting the electronics sub-assembly to the chassis such that it is movable to an expanded position. The method may comprise moving the electronics sub-assembly away from the chassis in the expanded position such that the heat transfer portion contacts a surface of the cavity during use. The method may comprise moving the electronics sub assembly between the retracted position for insertion of the subsea electronics assembly into the cavity of the housing, and the expanded position where the electronics sub-assembly is relatively further away from the chassis (relative to the retracted position) such that the heat transfer portion contacts a surface of the cavity during use. The method may comprise moving the electronics sub assembly relative to the chassis between the retracted and expanded positions to selectively extend the heat transfer portion outwards. The movement of the electronics sub assembly relative to the chassis may be linked to the position of the chassis in or within the cavity. In at least some examples, the movement of the electronics sub assembly is determined by the position of the chassis within the cavity. The method may comprise automatically expanding the sub electronics away from the chassis by the insertion of the chassis into the cavity.

### BRIEF DESCRIPTION OF THE DRAWINGS

Embodiments of the invention are further described hereinafter with reference to the accompanying drawings, in which:
FIG. 1 shows a subsea electronics module;
FIG. 2 shows the subsea electronics assembly of the subsea electronics module of FIG. 1, with the housing not shown;
FIGS. 3A and 3B show an electronics sub-assembly of the subsea electronics assembly of FIG. 2;
FIG. 4 shows an exploded view of the electronics sub-assembly of FIGS. 3A and 3B;
FIGS. 5A and 5B illustrate how the electronics sub-assembly of FIGS. 3A to 4 is mounted to the subsea electronics assembly shown in FIG. 2;
FIGS. 6A to 6C illustrate insertion of the subsea electronics assembly into the housing and movement of the electronics sub-assembly from a retracted position to an expanded position;
FIG. 7 shows the actuator of the subsea electronics assembly;
FIG. 8 shows an exploded view of another subsea electronics sub-assembly;
FIG. 9a shows the subsea electronics sub-assembly of FIG. 8 in a retracted configuration; and
FIG. 9b shows the subsea electronics sub-assembly of FIG. 8 in an expanded configuration.

### DETAILED DESCRIPTION

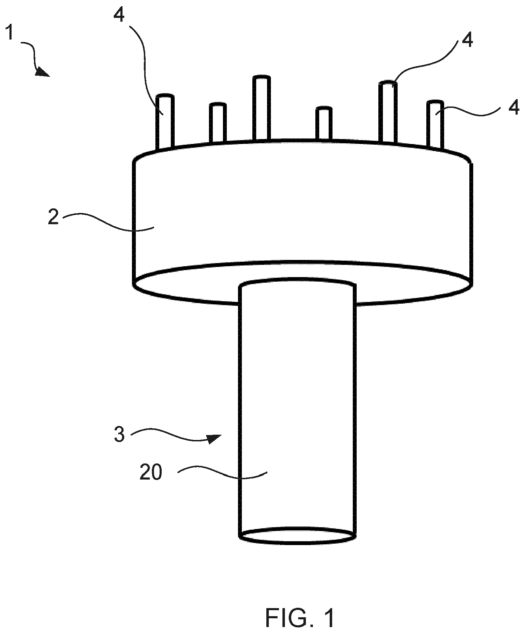

As shown in FIG. 1 the subsea electronics module (SEM) 1 comprises a connector assembly 2 and a subsea electronics assembly 3. The subsea electronics assembly 3 is housed in a housing 20 connected to, or extending from, the connector assembly 2. The housing 20 provides a sealed environment for the subsea electronics assembly 3. The subsea electronics assembly 3 may include power components, such as a transformer, a battery, a capacitor, and the like. The subsea electronics assembly 3 may additionally or alternatively comprise control electronics, such as one or more control circuits, sensors, and the like. The connector assembly 2 includes one or more connectors 4, in particular waterproof or underwater connectors, such as wet mate connectors, for connecting the subsea electronics assembly 3 to further components via cables. The connector assembly 2 may optionally include an ROV handle for engagement by an ROV for installation, control, and/or maintenance.

It will be appreciated that the electronic components of the subsea electronics assembly 3 will depend on the application of the SEM 1, for example if used for housing control apparatus for a subsea oil and gas well, or for housing electronics that control or monitor a subsea power distribution network such as for an offshore wind turbine. Nevertheless, the housing 20 provides a sealed environment for the subsea electronics assembly 3 and the connector assembly 2 provides for connecting the SEM 1 to further components.

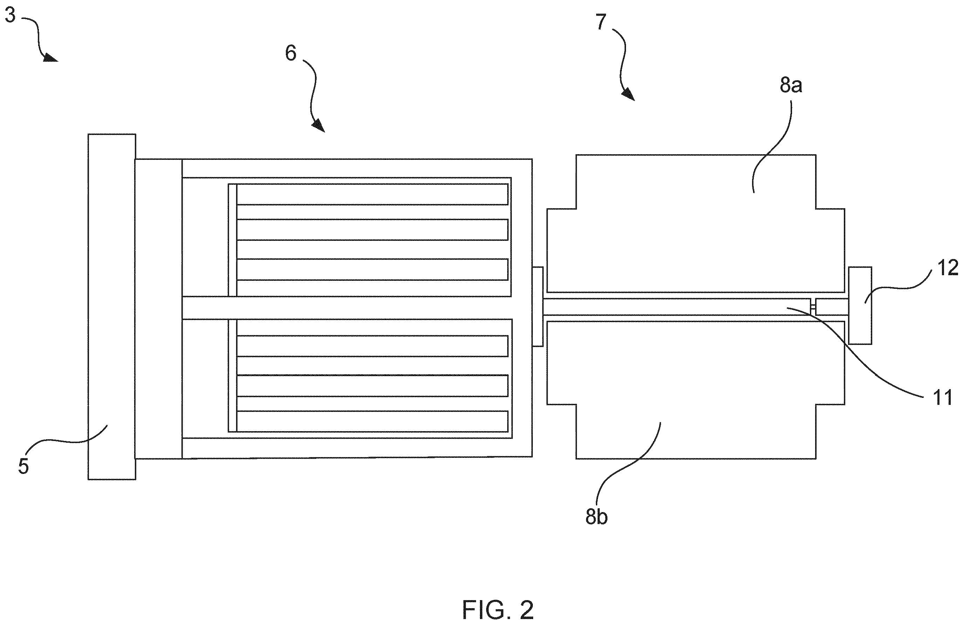

As show in FIG. 2, the subsea electronics assembly 3 housed in the housing (20, see FIG. 1) comprises an electronics unit 6 and a power supply unit 7. The electronics unit 6 may house electronics such as control circuits and the like, and as described further hereinafter the power supply unit 7 may house low and high voltage power components, particularly electronics components that generate significant amounts of heat during operation. However, control circuits and the like may be provided on the power supply unit 7 in addition to power components.

The subsea electronics assembly 3 also includes a sealing plate that engages the housing (20, see FIG. 1) to seal the interior of the housing (20, see FIG. 1). The sealing plate 5 may screw into the housing (20, see FIG. 1) or into a part of the connector assembly 2 which seals against the housing (20, see FIG. 1).

As illustrated in FIG. 2, the power supply unit 7 comprises a first electronics sub-assembly 8a and a second electronics sub-assembly 8b. Each of the first electronics sub-assembly 8a and the second electronics sub-assembly 8b are mounted to a chassis 11. As explained further hereinafter, each of the first electronics sub-assembly 8a and the second electronics sub-assembly 8b are movably mounted to the chassis 11 and movable between a retracted position that allows the power supply unit 7 to be inserted into the housing (20, see FIG. 1), and an expanded position where the electronics sub-assembly 7 is moved away from the chassis 11 and contacts an inner surface of the housing (20, see FIG. 1) to provide a conduction path for heat from each of the first and second electronics sub-assemblies 8a, 8b to the housing (20, see FIG. 1) and subsequently into the local environment.

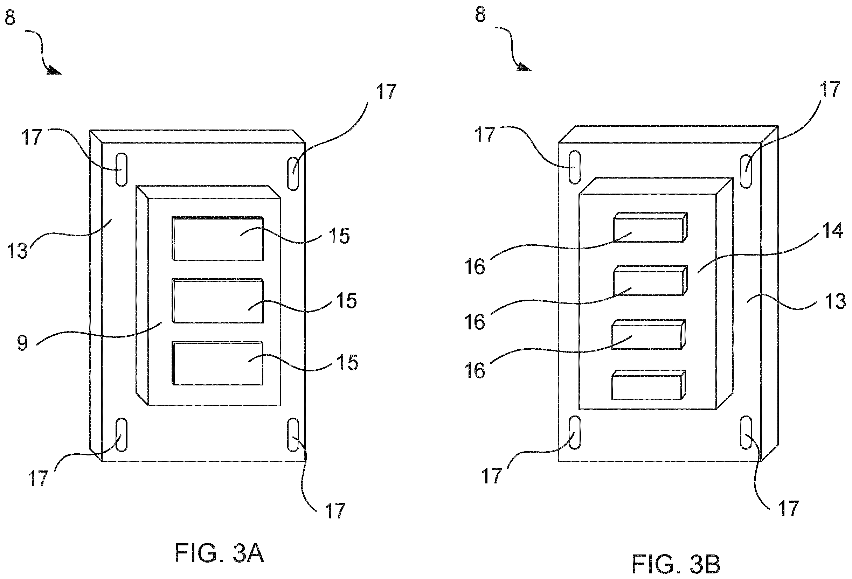

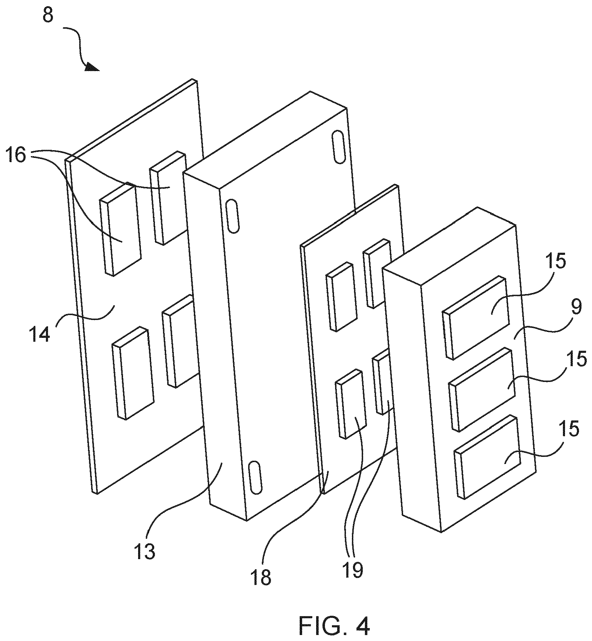

As shown in FIGS. 3A, 3B and 4, each electronics sub-assembly 8 comprises a frame 13. A low voltage power supply card 14 is attached to one side of the frame 13. A high voltage power supply card 18 is attached to an opposite side of the frame 13 to the low voltage power supply card 14. A heat transfer portion, for example a heat sink 9, is attached to the frame 13 on the side of the high voltage power supply card 18. The high voltage power supply card 18 is disposed between the frame 13 and the heat sink 9.

As shown in FIG. 4, components 16 of the low voltage power supply card 14 that generate heat (so called "hot components") are arranged to contact the frame 13. That is, the hot components 16 of the low voltage power supply card 14 are in contact with the frame 13 when the low voltage power supply card 14 is attached to the frame 13. Thermal bridges, for example using thermal adhesive or thermal paste, may be provided to improve contact.

In other examples, components 16 of the low voltage power supply card 14 may additionally or alternatively be arranged on an opposite side of the low voltage power supply card 14 to the frame 13, as shown in FIG. 3B.

Hot components 19 of the high voltage power supply card 18 are arranged to contact the frame 13 and/or the heat sink 9. That is, hot components 19 of the high voltage power supply card 18 are in contact with the frame 13 and/or the heat sink 9.

Hot components may comprise one or more transformers, one or more batteries, and/or one or more capacitors, or the like.

The heat sink 9, as illustrated, comprises a mass of heat conducting material, for example a metal such as aluminium, copper, or steel. In the illustrated example the heat sink 9 is attached to the frame 13 with the high voltage power supply card 18 sandwiched between the heat sink 9 and the frame 13.

The frame 13 includes one or more mounting points, in particular slotted openings 17, for attachment of the frame 13 (and the electronics sub-assembly 8) to the chassis (11, see FIG. 2), as described further below.

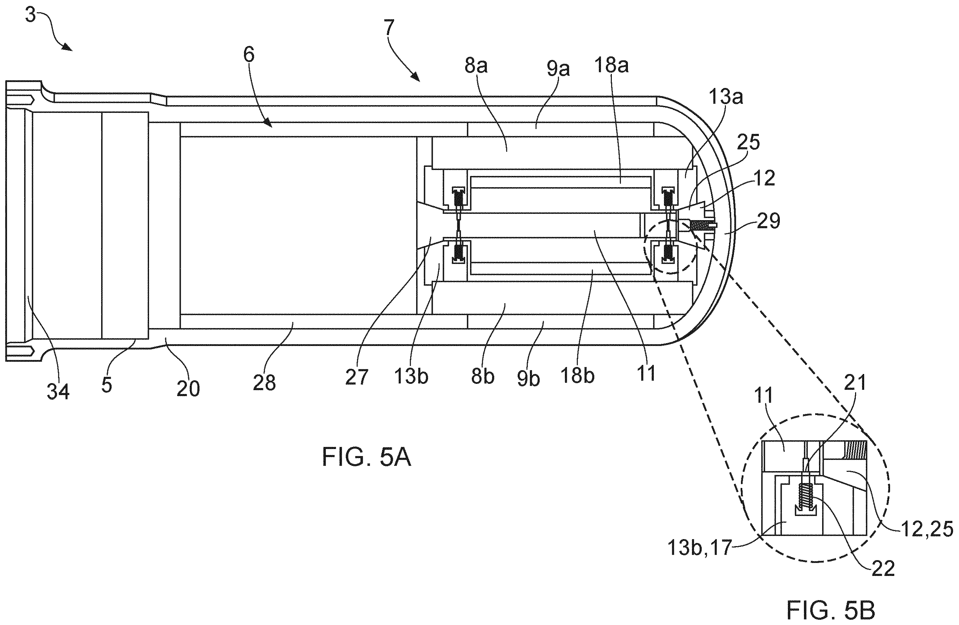

FIG. 5A shows a cross-section through the subsea electronics assembly 3, where the chassis 11, electronics unit 6, and power supply unit 7 are received in a cavity 28 of the housing 20. The housing 20 includes an open end 34 and the sealing plate 5 engages the housing 20 to seal the open end 34. The chassis 11 extend from the sealing plate 5 or from the electronics unit 6 towards an end 29 of the housing 20 opposite to the open end 34.

The housing 20 is elongate and may be generally cylindrical. In other examples, the elongate housing 20 may be a shape other than cylindrical, for example box-shaped.

Each of the first and second electronics sub-assemblies 8a, 8b are mounted to the chassis 11. The first and second electronics sub-assemblies 8a, 8b are mounted to the chassis 11 such that the heat sinks 9a, 9b are directed outwards, towards the housing 20.

In particular, as shown in FIGS. 5A and 5B, each of the first and second electronics sub-assemblies 8a, 8b is mounted to the chassis by one or more guides. In examples, the guides may be shafts or linear slides, and in the illustrated example the guides are formed by one or more fasteners 21. In this example the fasteners 21 are shoulder bolts.

The fasteners 21 pass through the slotted openings 17 in the frame 13 and engage threaded holes in the chassis 22. The fasteners 21 are thereby configured to permit movement of the first and second electronics sub-assemblies 8a, 8b relative to the chassis 11 along the direction of the fasteners 21. In particular, the fasteners 21 are arranged to permit movement of the first and second electronics sub-assemblies 8a, 8b in a radial direction of the housing 20 (i.e., a direction transverse to the direction between the open end 34 of the housing 20 and the closed end 29 of the housing 20. The electronics sub-assemblies 8a, 8b can thereby move between a retracted position where they are towards, or in contact with, the chassis 11, and an expanded position where they are moved away from the chassis 11 such that they are spaced from the chassis 11.

The slotted openings (17, see FIG. 3B) in the frames 13 also permit movement of the electronics sub-assemblies 8, 8b in an axial direction of the housing 20 by the fasteners 21 moving within the slots of the slotted openings (17, see FIG. 3B) and to the extent permitted by the slotted openings (17, see FIG. 3B).

Biasing members, in this example springs 22, are provided on the fasteners 21 to act between a part of each fastener 21 (in particular a head of each fastener 21) and the frame 13a, 13b. The springs 22 are arranged to urge the frame 13a, 13b (and with it the corresponding electronics sub-assemblies 8a, 8b) towards the chassis 11, into the retracted position. Accordingly, the fasteners 21 act as guides that permit movement of the electronics sub-assemblies 8a, 8b towards and away from the chassis 11, and the springs 22 act to urge the electronics sub-assemblies 8a, 8b towards the chassis 11, into the retracted position.

As shown in FIGS. 5A and 5B, an actuator 12 is provided to move the first and second electronics sub-assemblies 8a, 8b from the retracted position into the expanded position. In particular, the actuator 12 is configured to push the first and second electronics sub-assemblies 8a, 8b away from the chassis 11, in a radial direction relative to the housing 20.

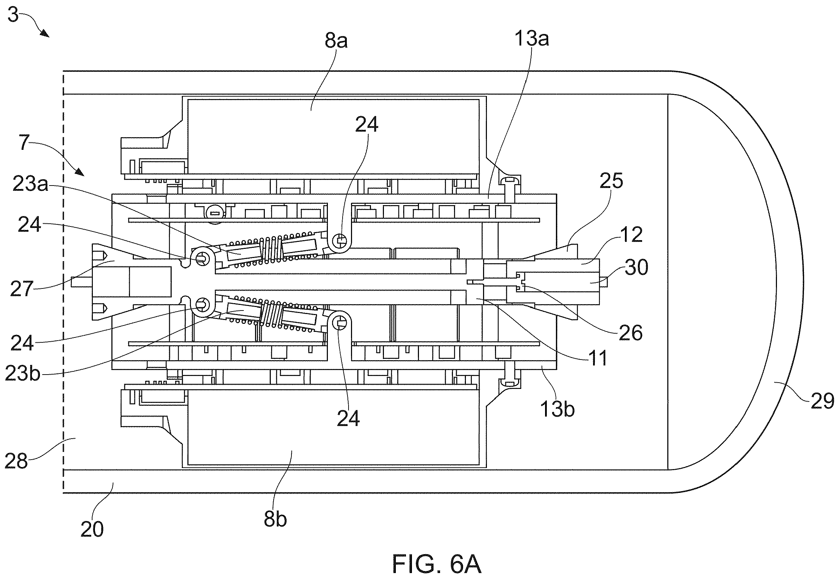

The actuator 12 comprises a wedge-shaped portion 25 having inclined surfaces. As explained in further detail with reference to FIGS. 6A to 6C, on insertion of the power supply unit 7 into the housing 20 the actuator 12 moves in an axial direction and the inclined surfaces push the frames 13a, 13b away from the chassis 11 to move the first and second electronics sub-assemblies 8a, 8b into the expanded position. The wedge-shaped portion 25 is arranged to act on the frames 13a, 13b at an end of the power supply unit 7 proximal to the closed end 29 of the housing 20.

As shown in FIGS. 5A and 5B and explained further below, the actuator 12 is slidably mounted to the chassis 11 and moves axially to push the first and second electronics sub-assemblies 8a, 8b. As explained above, the first and second electronics sub-assemblies 8a, 8b are also movable in an axial direction along the slotted openings (17, see FIG. 3B), so the actuator 12 also moves the first and second electronics sub-assemblies 8a, 8b in an axial direction. The chassis 11 comprises an opposing pushing member 27 arranged to act on the frames 13a, 13b at the ends of the frames 13a, 13b opposite to the wedge-shaped portion 25 when the first and second electronics sub-assemblies 8a, 8b move axially along the slotted openings (17, see FIG. 3B). Accordingly, the frames 13a, 13b are pushed at both ends to move into the expanded position.

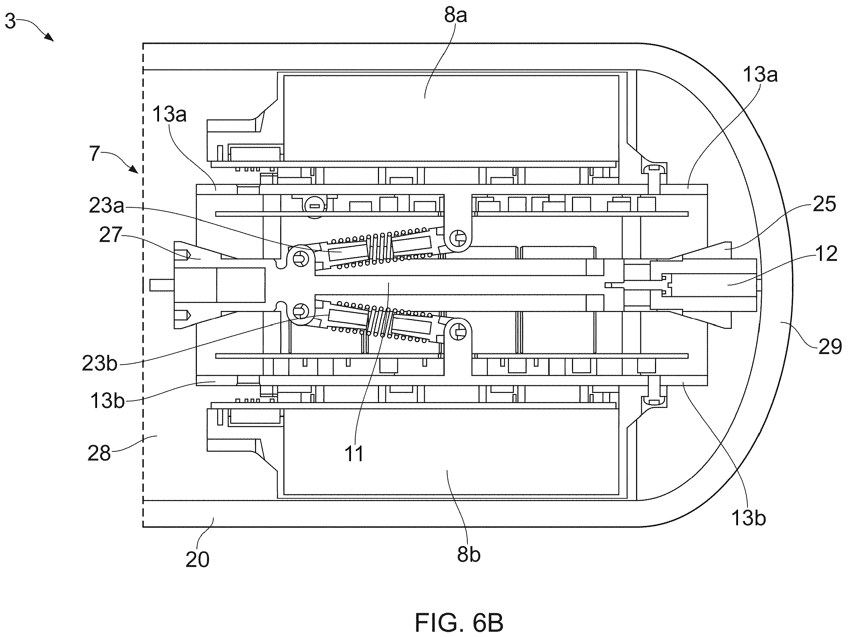

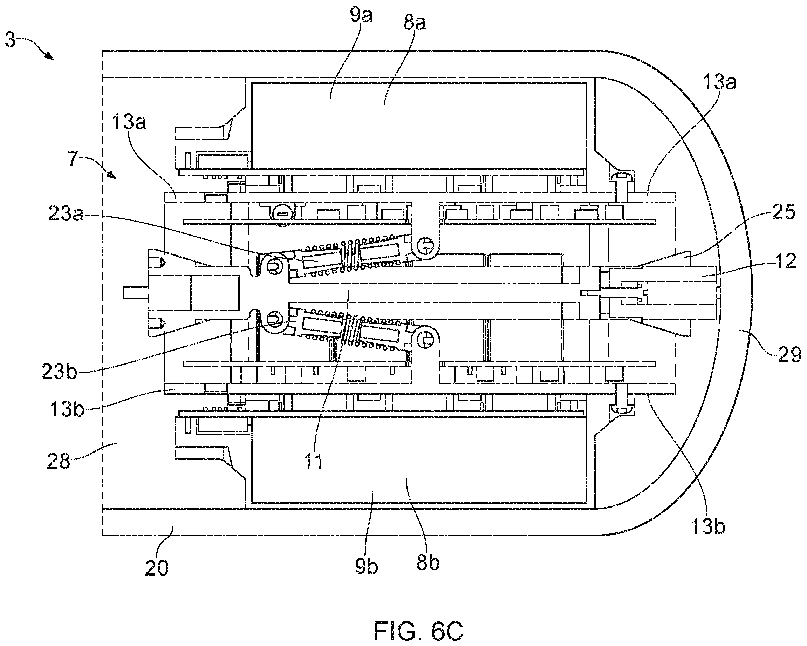

FIG. 6A shows a cross-section through the subsea electronics assembly 3 at parallel but an offset position compared to FIG. 5A. As shown in FIG. 6, at least one axial biasing member, in this example two axial biasing springs 23a, 23b, are arranged to act between the chassis 11 and the frames 13a, 13b. In particular, the axial biasing springs 23a, 23b are connected to the chassis 11 and to the frames 13a, 13b at pivots 24. The axial biasing springs 23a, 23b are arranged to bias the first and second electronics sub-assemblies 8a, 8b to centralise the first and second electronics sub-assemblies 8a, 8b in the slotted openings (17, see FIG. 3B). The pivots 24 permit movement of the first and second electronics sub-assemblies 8a, 8b towards and away from the chassis 11 in the radial direction, to move between the retracted and expanded positions.

FIG. 6A also shows the actuator 12 in more detail. As show, the actuator 12 has a wedge-shaped portion 25 adapted to engage the frames 13a, 13b. The actuator 12 also comprises a bore 30 and a fastener 26 located with its head in the bore 30 and extending through the actuator 12 to engage an end of the chassis 11. Accordingly, the actuator 12 can slide relative to the chassis 11 in an axial direction. The actuator 12 and/or chassis 11 may be correspondingly shaped to permit sliding in the axial direction.

Referring to FIG. 6A, when the actuator 12 moves axially towards the chassis 11 the wedge-shaped portion 25 acts to push the frames 13a, 13b (and the first and second electronics sub-assemblies 8a, 8b) radially outward and into the expanded position. This movement also causes the first and second electronics sub-assemblies 8a, 8b to move axially and the opposing pushing member 27 on the chassis 11 acts to push the frames 13a, 13b at the opposite end. Accordingly, the first and second electronics sub-assemblies 8a, 8b are pushed into the expanded position at both ends, ensuring smooth movement and preventing jams.

FIGS. 6B and 6C illustrate insertion of the subsea electronics assembly 3 and power supply unit 7 into the housing 20. FIG. 6A shows the power supply unit 7 before it reaches the end 29 of the housing 20. In this position, springs (22, see FIGS. 5A and 5B) act to urge the first and second electronics sub-assemblies 8a, 8b towards the chassis 11 and hold the first and second electronics sub-assemblies 8a, 8b in a retracted position. At the same time, the axial biasing springs 23a, 23b hold the first and second electronics sub-assemblies 8a, 8b in an axial position corresponding approximately to the middle of the slotted openings (17, see FIG. 3B). In the retracted position the frames 13a, 13b of the first and second electronics sub-assemblies 8a, 8b are proximate to the chassis 11, and may be in contact with the chassis 11. In the retracted position there is a clearance (not shown) between the outer faces of the first and second electronics sub-assemblies 8a, 8b (in particular the heat sinks 9a, 9b, see FIGS. 3A to 4) and the inner surface of the housing 20. Accordingly, the subsea electronics assembly 3 and power supply unit 7 can be inserted into the housing 20.

As shown in FIG. 6B, when the power supply unit 7 reaches the end of the housing 20 the actuator 12 contacts the closed end 29 of the housing 20. As shown in FIG. 6C, further insertion of the power supply unit 7 into the housing 20 pushes the actuator 12 in an axial direction towards the chassis 11. The wedge-shaped portion 25 of the actuator 12 then acts to push the frames 13a, 13b outwards until the first and second electronics sub-assemblies 8a, 8b, in particular the heat sinks 9a, 9b (see FIGS. 3A and 4), engage the inner surface of the housing 20.

As described above, as the actuator 12 moves axially and pushes on the frames 13a, 13b the first and second electronics sub-assemblies 8a, 8b move axially a small amount and deflect the axial biasing springs 23a, 23b, which means that the opposing pushing member 27 on the chassis 11 acts to simultaneously push the other ends of the frames 13a, 13b outwards, towards the expanded position.

Accordingly, as the power supply unit 7 reaches the closed end 29 of the housing 12 the actuator 12 causes the first and second electronics sub-assemblies 8a, 8b to move into the expanded position in which they are pushed against the inner surface of the cavity 28 of the housing 20.

The contact between the first and second electronics sub-assemblies 8a, 8b and the housing 20, in particular between the heat sinks 9a, 9b and the housing 20, ensures an efficient conductive path between the electronics components 16, 19 of the power supply unit 7 and the housing 20. Advantageously, the electronics components 16, 19 of the power supply unit 7 are moved with the frame 13 and heat sink 9 into the engaged position, so there is no need for a flexible or moving heat transfer member to be provided.

With reference to FIGS. 3A to 4 and FIG. 6C, the outer surface of the heat sink 9 may be shaped to match the profile of the inner surface of the cavity 28 of the housing 20, to provide increased surface area contact between the heat sink 9 and the housing 20. The heat sink 9 may include thermal pads 15 that provide efficient heat transfer from the heat sink 9 to the housing 20. The thermal pads 15 may be conformable or deformable to closely conform to the shape of the inner surface of the housing 20.

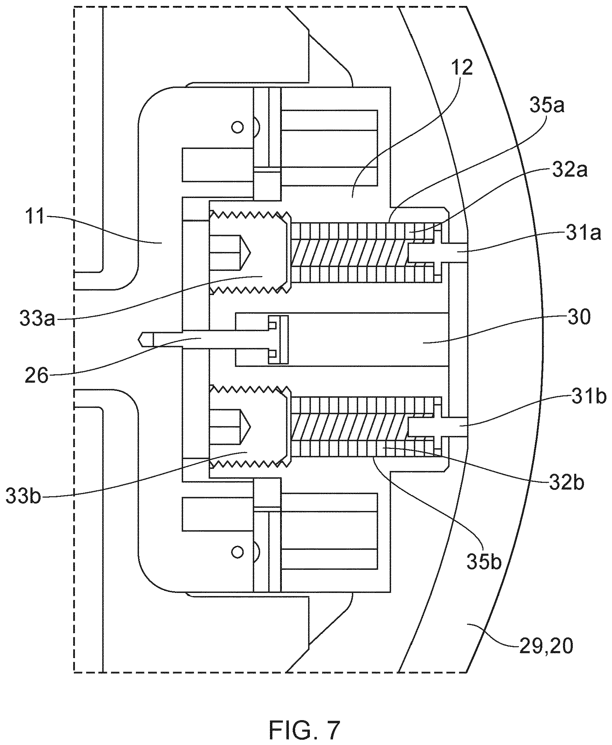

FIG. 7 illustrates the actuator 12 in more detail. In particular, FIG. 7 shows a cross-section of the actuator 12 and an end of the chassis 11 that is perpendicular to the planes of the cross-sections of FIGS. 5 and 6A to 6C. As shown and described above, the actuator 12 includes a bore 30 and a fastener 26 positioned in the bore to slidably attach the actuator 12 to the chassis 11. The actuator 12 also comprises at least one, in this example two, protruding pins 31a, 31b that protrude towards the closed end 29 of the housing 20. The protruding pins 31a, 31b are the parts of the actuator 12 that contact the closed end 29 of the housing 20 during insertion of the power supply unit (7, see FIGS. 6A to 6C) into the housing 2.

As shown, the protruding pins 31a, 31b are retained in pin bores 35a, 35b formed in the actuator 12. Compression springs 32a, 32b act to urge the protruding pins 31a, 31b outward. Set screws 33a, 33b are provided to adjust the pre-tension of the compression springs 32a, 32b. When the protruding pins 31a, 31b contact the closed end 29 of the housing 20 they act to compress the compression springs 32a, 32b, providing some slack to account for tolerancing of the other components. In addition, once the power supply unit (7, see FIGS. 6A to 6C) is inserted into the housing 20, as shown in FIG. 6C, the compression springs 32a, 32b are acting to push the actuator towards the chassis 11 and so are also urging the first and second electronics sub-assemblies 8a, 8b towards the expanded position. Accordingly, the protruding pins 31a, 31b and compression springs 32a, 32b advantageously provide for variation in tolerances while maintaining substantially the same force acting to urge the first and second electronics sub-assemblies 8a, 8b into the expanded position. Therefore, small tolerances can be accounted for while maintaining the first and second electronics sub-assembles 8a, 8b in contact with the housing 20.

In alternative examples the actuator 12 may be mounted to the housing 20, in particular to the end 29 of the housing 20. The actuator 12 can be mounted so as to engage the first and second electronics sub-assemblies 8a, 8b as they are inserted into the housing 20 and to move the first and second electronics sub-assemblies 8a, 8b in the same manner as described above. In such examples the actuator 12 may be spring-loaded so as to account for tolerances and to ensure that the first and second electronics sub-assemblies 8a, 8b are pressed against the housing 20 as described above.

In other examples the actuator 12 may be operable from the opposite end of the chassis 11, and in particular from at or near the sealing plate 5 shown in FIG. 2. In particular, a threaded shaft may engage the actuator 12 and be rotatable from at or near the sealing plate 5 so as to pull the actuator 12 in the axial direction and move the first and second electronics sub-assemblies 8a, 8b into the expanded position. Accordingly, the actuator 12 does not need to abut the end 29 of the housing 20 and the subsea electronics assembly 3 can be installed at a position spaced from the end 29 of the housing 20.

In some examples the subsea electronics assembly 3 may comprise only one electronics sub-assembly 8a. In such an example the electronics sub-assembly 8a is movable to an expanded position to engage the housing 20. Similarly, in other examples the subsea electronics assembly 3 may comprise more than two electronics sub-assemblies, for example three or four. Each of the electronics sub-assemblies is movable to an expanded position. The electronics sub-assemblies may be circumferentially spaced about the subsea electronics assembly 3 and movable in a radial direction into the expanded position.

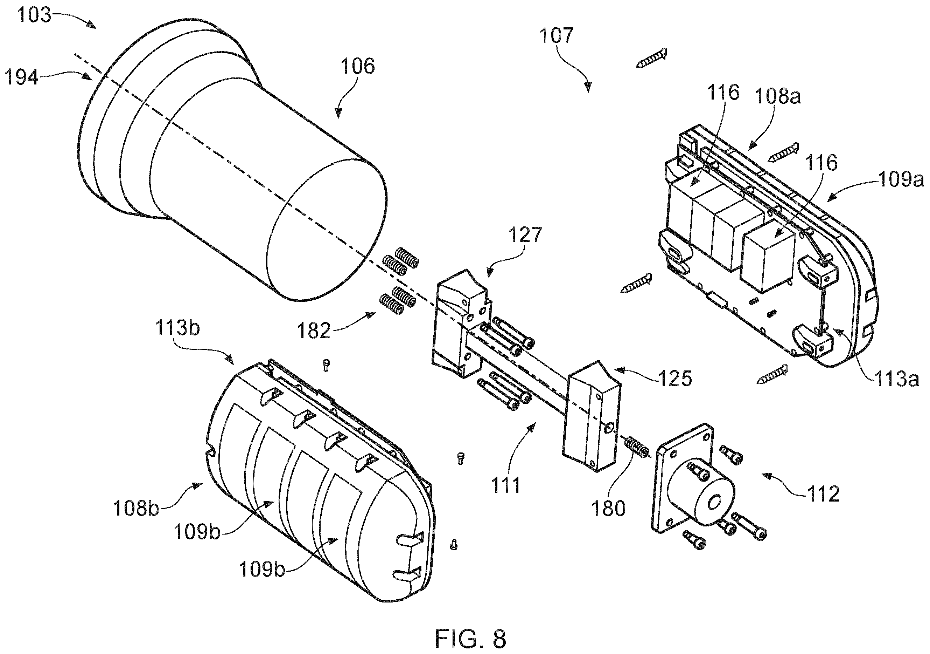

Referring now to FIG. 8, there is shown an exploded view of another subsea electronics sub-assembly 103. The subsea electronics sub-assembly 103 is generally similar to that 3 shown in FIGS 1 to 7, with similar features denoted by similar reference numerals, incremented by 100. Accordingly, the subsea electronics sub-assembly 103 comprises an electronics unit 106 and a power supply unit 107. As shown here, the power supply unit 107 comprises a first electronics sub-assembly 108a and a second electronics sub-assembly 108b. Each of the first electronics sub-assembly 108a and the second electronics sub-assembly 108b are mounted to a chassis 111. Similar to that shown in FIGS 1 to 7, each of the first electronics sub-assembly 108a and the second electronics sub-assembly 108b are movably mounted to the chassis 111 and movable between a retracted position that allows the power supply unit 107 to be inserted into the housing (not shown), and an expanded position where the electronics sub-assembly 107 is moved away from the chassis 111 and contacts an inner surface of the housing to provide a conduction path for heat from each of the first and second electronics sub-assemblies 108a, 108b to the housing and subsequently into the local environment.

The chassis 111 of the PSU 107 of the embodiment shown in FIGS 8-9b is mechanically connected to the electronics unit 106 via a flexible coupling 182, shown here in the form of springs. Accordingly there is provided a degree of flexibility between the electronics unit 106 and the PSU 107, with the respective central longitudinal axis 180, 194 of each being allowed to deviate, particularly angularly, with respect to each other. As such, the chassis 111 of the PSU 107 can be considered as a distinct chassis from that 184 of the electronics unit 106.

As shown in FIGS 8 to 9a, the actuator 112 comprises a wedge-shaped portion 125 having inclined surfaces such that, on insertion of the power supply unit 107 into the housing (not shown) the actuator 112 moves in an axial direction and the inclined surfaces push the frames 113a, 113b away from the chassis 111 to move the first and second electronics sub-assemblies 108a, 108b into the expanded position.

Here, the front wedge-shaped portion 125 is arranged to act on the frames 113a, 113b at an end of the power supply unit 107 proximal to the closed end of the housing (not shown in FIGS 8 - 9b). In the embodiment shown here, the front wedge-shaped portion 125 is generally parallel and aligned with a corresponding wedge-shaped portion 127 that is arranged to act on the frames 113a, 113b at the ends of the frames 113a, 113b opposite to the wedge-shaped portion 125 when the first and second electronics sub-assemblies 108a, 108b move axially. In the embodiment shown in FIGS 8-9b, when the stopper at the front end of the power supply unit 107 contacts the closed end of the housing, the stopper engages the wedge portion 125 such that there is only a pure lateral movement instigated by the wedge-portion 125 acting as a cam. Accordingly, no pressure is exerted on soft pads located on the outside of the heat sinks 109a, 109b.

The hot components 116 of the first electronics sub-assembly 108a are arranged on a first lateral side of the PSU107; whilst the hot components 116 of the second electronics sub-assembly 108b are arranged on a second lateral side of the PSU 107. Here, the respective hot components 116 are arranged on opposite sides (top and bottom respectively as shown in FIG. 8) of the chassis 111 of the PSU 107. The hot components 116 here are similarly-arranged capacitors on the respective PCB of each PSU 107.

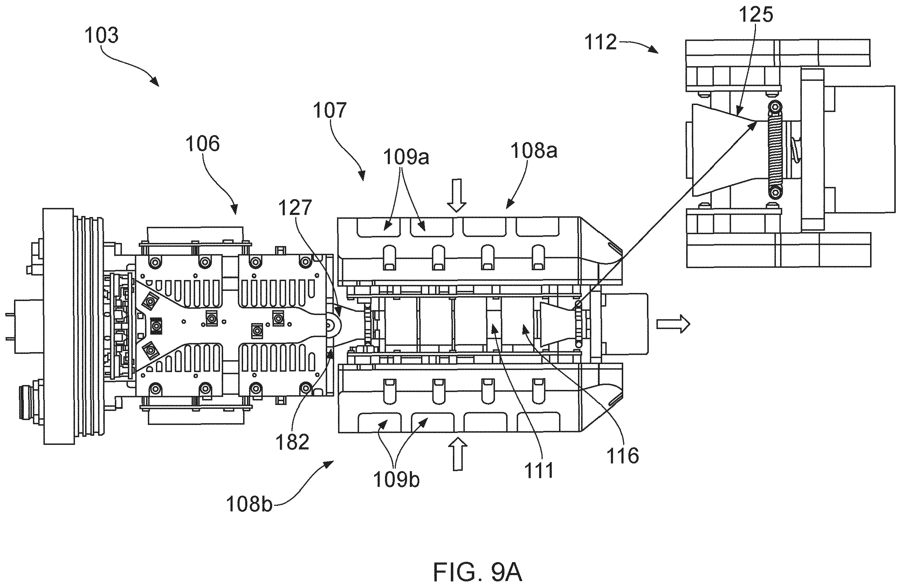

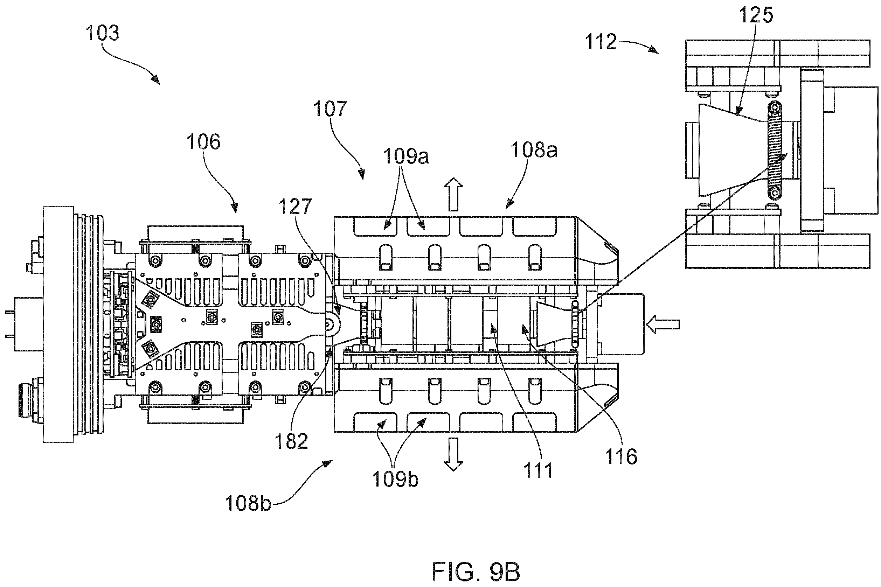

FIG. 9a shows the subsea electronics sub-assembly of FIG. 8 in a retracted configuration; and FIG. 9b shows the subsea electronics sub-assembly of FIG. 8 in an expanded configuration. As can be seen from the detail views of each of FIGS 9a and 9b, the actuator 112 moves the first and second electronics sub-assemblies 108a, 108b from the retracted position of FIG. 9a into the expanded position of FIG.9b. In particular, the actuator 112 is configured to push the first and second electronics sub-assemblies 108a, 108b away from the chassis 111, in a purely radial direction relative to the housing (not shown), as indicated by the vertical arrows in FIG.9b.

Throughout the description and claims of this specification, the words "comprise" and "contain" and variations of them mean "including but not limited to", and they are not intended to (and do not) exclude other components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The invention is not restricted to the details of any foregoing embodiments.

## Claims

1. A subsea electronics assembly (3) for mounting in a cavity (28) of a housing (20), the subsea electronics assembly comprising a chassis (11) and an electronics sub-assembly (8a) having an electronic component and a heat transfer portion (9), wherein the electronics sub-assembly is movably mounted to the chassis such that it is movable between a retracted position for insertion of the subsea electronics assembly into the cavity (28) of the housing (20), and an expanded position where the electronics sub-assembly (8a) is moved away from the chassis (11) such that the heat transfer portion (9) contacts a surface of the cavity (28) during use, **characterized in that** it further comprises one or more first biasing members (22) arranged to bias the electronics sub-assembly (8a) towards the retracted position.

2. The subsea electronics assembly (3) of claim 1, wherein the electronics sub-assembly (8a) is mounted to the chassis (11) on one or more guides (21) arranged to guide the movement of the electronics sub-assembly relative to the chassis.

3. The subsea electronics assembly (3) of claim 1 or claim 2, wherein the electronics sub-assembly (8a) is movable relative to the chassis (11) in two translational degrees of freedom.

4. The subsea electronics assembly (3) of any preceding claim, further comprising one or more second biasing members (23a, 23b) arranged to act on the electronics sub-assembly (8a) in a direction substantially perpendicular to the one or more first biasing members (22).

5. The subsea electronics assembly (3) of any preceding claim, further comprising an actuator (12) configured to move the electronics sub-assembly (8a) relative to the chassis and, optionally,
wherein the actuator (12) is operable to move the electronics sub-assembly (8a) from the retracted position to the expanded position.

6. The subsea electronics assembly (3) of claim 5, wherein the actuator (12) comprises a pushing member having an inclined surface (25) adapted to engage the electronics sub-assembly (8a) to push the electronics sub-assembly away from the chassis (11) and into the expanded position.

7. The subsea electronics assembly (3) of claim 6, wherein the actuator (12) is slidably mounted to the chassis (11).

8. The subsea electronics assembly (3) of claim 6 or claim 7, wherein the actuator (12) is arranged such that on insertion of the subsea electronics assembly (8a) into the cavity (28) the actuator engages a surface of the cavity and the pushing member is moved relative to the chassis (11) to move the electronics sub-assembly towards the expanded position.

9. The subsea electronics assembly (3) of claim 7 or claim 8, wherein the pushing member comprises a spring-loaded pin (31a, 31b) protruding from the pushing member and arranged to engage the surface of the cavity (28).

10. The subsea electronics assembly (3) of any of claims 7 to 9, wherein the chassis (11) comprises a second pushing member (27) having an inclined surface arranged in alignment, parallel to the inclined surface of the pushing member and disposed on an opposite end of the electronics sub-assembly (8a).

11. The subsea electronics assembly (3) of any of claims 7 to 10, wherein the chassis (11) comprises a second pushing member (27) having an inclined surface arranged oppositely to the inclined surface of the pushing member and disposed on an opposite side of the electronics sub-assembly (8a).

12. The subsea electronics assembly (3) of any preceding claim, comprising a second electronics sub-assembly (8b) movably mounted to the chassis (11) and movable between a retracted position for insertion of the subsea electronics assembly into the cavity (28) of the housing (20), and an expanded position where the second electronics sub-assembly (8b) is moved away from the chassis for contacting a surface of the cavity of the housing during use and, optionally,
wherein the second electronics sub-assembly (8b) is mounted to an opposite side of the chassis (11) to the electronics sub-assembly (8a), and/or
wherein each of the first and second electronics sub-assemblies (8a, 8b) comprises a PCB, each PCB comprising a same shape and routing layout.

13. The subsea electronics assembly of any preceding claim, wherein the subsea electronics assembly comprises a housing sealing portion (5) and the electronics sub assembly/ies is/are flexibly connected to the housing sealing portion.

14. A subsea electronics module (1) comprising the subsea electronics assembly (3) of any preceding claim, and a housing (20) having a cavity (28) adapted to receive the subsea electronics assembly and, optionally,
wherein the housing (20) is elongate and the cavity (28) comprises a side wall, a closed end (29), and an open end (34), and wherein in the expanded position the electronics sub-assembly (8a) is in contact with the side wall.

15. The subsea electronics module of claim 14, wherein the housing (20) comprises an actuator (12) configured to move the electronics sub-assembly (8a) into the expanded position on insertion of the subsea electronics assembly (3) into the cavity (28) and, optionally,
wherein the actuator (12) comprises a pushing member (25) having an inclined surface adapted to push the electronics sub-assembly away (3) from the chassis (11) and towards the expanded position as the subsea electronics assembly is inserted into the cavity (28).

## Patentansprüche

1. Unterwasserelektronikbaugruppe (3) zum Montieren in einem Hohlraum (28) eines Gehäuses (20), die Unterwasserelektronikbaugruppe umfassend ein Chassis (11) und eine Elektronikunterbaugruppe (8a), die eine elektronische Komponente und einen Wärmeübertragungsabschnitt (9) aufweist, wobei die Elektronikunterbaugruppe an dem Chassis derart bewegbar montiert ist, dass sie zwischen einer eingefahrenen Position für Einführung der Unterwasserelektronikbaugruppe in den Hohlraum (28) des Gehäuses (20) und einer ausgefahrenen Position, in der die Elektronikunterbaugruppe (8a) von dem Chassis (11) derart wegbewegt ist, dass der Wärmeübertragungsabschnitt (9) während einer Verwendung eine Oberfläche des Hohlraums (28) berührt, bewegbar ist, **dadurch gekennzeichnet, dass** sie ferner ein oder mehrere erste Vorspannelemente (22), die arrangiert sind, um die Elektronikunterbaugruppe (8a) zu der eingefahrenen Position vorzuspannen, umfasst.

2. Unterwasserelektronikbaugruppe (3) nach Anspruch 1, wobei die Elektronikunterbaugruppe (8a) an dem Chassis (11) auf einer oder mehreren Führungen (21), die arrangiert sind, um die Bewegung der Elektronikunterbaugruppe relativ zu dem Chassis zu führen, montiert ist.

3. Unterwasserelektronikbaugruppe (3) nach Anspruch 1 oder 2, wobei die Elektronikunterbaugruppe (8a) relativ zu dem Chassis (11) in zwei translatorischen Freiheitsgraden bewegbar ist.

4. Unterwasserelektronikbaugruppe (3) nach einem der vorstehenden Ansprüche, ferner umfassend ein oder mehrere zweite Vorspannelemente (23a, 23b), die arrangiert sind, um auf die Elektronikunterbaugruppe (8a) in eine Richtung im Wesentlichen senkrecht zu dem einen oder den mehreren ersten Vorspannelementen (22) zu wirken.

5. Unterwasserelektronikbaugruppe (3) nach einem der vorstehenden Ansprüche, ferner umfassend einen Stellantrieb (12), der konfiguriert ist, um die Elektronikunterbaugruppe (8a) relativ zu dem Chassis zu bewegen, und, optional,
wobei der Stellantrieb (12) betriebsfähig ist, um die Elektronikunterbaugruppe (8a) von der eingefahrenen Position in die ausgefahrene Position zu bewegen.

6. Unterwasserelektronikbaugruppe (3) nach Anspruch 5, wobei der Stellantrieb (12) ein Schubelement umfasst, das eine geneigte Oberfläche (25) aufweist, geeignet, um die Elektronikunterbaugruppe (8a) in Eingriff zu nehmen, um die Elektronikunterbaugruppe von dem Chassis (11) weg und in die ausgefahrene Position zu schieben.

7. Unterwasserelektronikbaugruppe (3) nach Anspruch 6, wobei der Stellantrieb (12) an dem Chassis (11) gleitbar montiert ist.

8. Unterwasserelektronikbaugruppe (3) nach Anspruch 6 oder 7, wobei der Stellantrieb (12) derart arrangiert ist, dass bei Einführung der Unterwasserelektronikbaugruppe (8a) in den Hohlraum (28) der Stellantrieb eine Oberfläche des Hohlraums in Eingriff nimmt und das Schubelement relativ zu dem Chassis (11) bewegt wird, um die Elektronikunterbaugruppe zu der ausgefahrenen Position zu bewegen.

9. Unterwasserelektronikbaugruppe (3) nach Anspruch 7 oder 8, wobei das Schubelement einen federbelasteten Stift (31a, 31b), der von dem Schubelement vorsteht und arrangiert ist, um die Oberfläche des Hohlraums (28) in Eingriff zu nehmen, umfasst.

10. Unterwasserelektronikbaugruppe (3) nach einem der Ansprüche 7 bis 9, wobei das Chassis (11) ein zweites Schubelement (27), das eine geneigte Oberfläche aufweist, die in Ausrichtung parallel zu der geneigten Oberfläche des Schubelements arrangiert und auf einem gegenüberliegenden Ende der Elektronikunterbaugruppe (8a) angeordnet ist, umfasst.

11. Unterwasserelektronikbaugruppe (3) nach einem der Ansprüche 7 bis 10, wobei das Chassis (11) ein zweites Schubelement (27), das eine geneigte Oberfläche aufweist, die gegenüber zu der geneigten Oberfläche des Schubelements arrangiert und auf einer gegenüberliegenden Seite der Elektronikunterbaugruppe (8a) angeordnet ist, umfasst.

12. Unterwasserelektronikbaugruppe (3) nach einem der vorstehenden Ansprüche, umfassend eine zweite Elektronikunterbaugruppe (8b), die an dem Chassis (11) bewegbar montiert ist und zwischen einer eingefahrenen Position für Einführung der Unterwasserelektronikbaugruppe in den Hohlraum (28) des Gehäuses (20) und einer ausgefahrenen Position, in der die zweite Elektronikunterbaugruppe (8b) von dem Chassis zum Berühren einer Oberfläche des Hohlraums des Gehäuses während der Verwendung wegbewegt ist, bewegbar ist, und, optional,
wobei die zweite Elektronikunterbaugruppe (8b) an einer der Elektronikunterbaugruppe (8a) gegenüberliegenden Seite des Chassis (11) montiert ist, und/oder
wobei jede der ersten und der zweiten Elektronikunterbaugruppe (8a, 8b) eine LP umfasst, jede LP umfassend eine gleiche Form und ein gleiches Routing-Layout.

13. Unterwasserelektronikbaugruppe nach einem der vorstehenden Ansprüche, wobei die Unterwasserelektronikbaugruppe einen Gehäusedichtungsabschnitt (5) umfasst und die Elektronikunterbaugruppe(n) mit dem Gehäusedichtungsabschnitt flexibel verbunden ist/sind.

14. Unterwasserelektronikmodul (1), umfassend die Unterwasserelektronikbaugruppe (3) nach einem der vorstehenden Ansprüche und ein Gehäuse (20), das einen Hohlraum (28), der geeignet ist, um die Unterwasserelektronikbaugruppe aufzunehmen, aufweist, und, optional,
wobei das Gehäuse (20) länglich ist und der Hohlraum (28) eine Seitenwand, ein geschlossenes Ende (29) und ein offenes Ende (34) umfasst, und wobei in der ausgefahrenen Position die Elektronikunterbaugruppe (8a) in Berührung mit der Seitenwand ist.

15. Unterwasserelektronikmodul nach Anspruch 14, wobei das Gehäuse (20) einen Stellantrieb (12), der konfiguriert ist, um die Elektronikunterbaugruppe (8a) bei Einführung der Unterwasserelektronikbaugruppe (3) in den Hohlraum (28) in die ausgefahrene Position zu bewegen, und, optional,
wobei der Stellantrieb (12) ein Schubelement (25) umfasst, das eine geneigte Oberfläche aufweist, geeignet, um die Elektronikunterbaugruppe (3) von dem Chassis (11) weg und zu der ausgefahrenen Position zu schieben, sobald die Unterwasserelektronikbaugruppe in den Hohlraum (28) eingeführt wird.

## Revendications

1. Ensemble électronique sous-marin (3) destiné à être monté dans une cavité (28) d'un boîtier (20), l'ensemble électronique sous-marin comprenant un châssis (11) et un sous-ensemble électronique (8a) ayant un composant électronique et une partie de transfert de chaleur (9), dans lequel le sous-ensemble électronique est monté de manière déplaçable sur le châssis de telle sorte qu'il est déplaçable entre une position rétractée pour l'insertion de l'ensemble électronique sous-marin dans la cavité (28) du boîtier (20), et une position déployée où le sous-ensemble électronique (8a) est déplacé à l'écart du châssis (11) de telle sorte que la partie de transfert de chaleur (9) entre en contact avec une surface de la cavité (28) pendant l'utilisation,
**caractérisé en ce qu'**il comprend en outre un ou plusieurs premiers éléments de sollicitation (22) agencés pour solliciter le sous-ensemble électronique (8a) vers la position rétractée.

2. Ensemble électronique sous-marin (3) selon la revendication 1, dans lequel le sous-ensemble électronique (8a) est monté sur le châssis (11) sur un ou plusieurs guides (21) agencés pour guider le déplacement du sous-ensemble électronique par rapport au châssis.

3. Ensemble électronique sous-marin (3) selon la revendication 1 ou la revendication 2, dans lequel le sous-ensemble électronique (8a) est déplaçable par rapport au châssis (11) selon deux degrés de liberté de translation.

4. Ensemble électronique sous-marin (3) selon l'une quelconque revendication précédente, comprenant en outre un ou plusieurs seconds éléments de sollicitation (23a, 23b) agencés pour agir sur le sous-ensemble électronique (8a) dans une direction sensiblement perpendiculaire au ou aux premiers éléments de sollicitation (22).

5. Ensemble électronique sous-marin (3) selon l'une quelconque revendication précédente, comprenant en outre un actionneur (12) conçu pour déplacer le sous-ensemble électronique (8a) par rapport au châssis et, éventuellement,
dans lequel l'actionneur (12) est opérationnel pour déplacer le sous-ensemble électronique (8a) de la position rétractée à la position déployée.

6. Ensemble électronique sous-marin (3) selon la revendication 5, dans lequel l'actionneur (12) comprend un élément de poussée ayant une surface inclinée (25) adaptée pour venir en prise avec le sous-ensemble électronique (8a) pour pousser le sous-ensemble électronique à l'écart du châssis (11) et jusque dans la position déployée.

7. Ensemble électronique sous-marin (3) selon la revendication 6, dans lequel l'actionneur (12) est monté de manière coulissante sur le châssis (11).

8. Ensemble électronique sous-marin (3) selon la revendication 6 ou la revendication 7, dans lequel l'actionneur (12) est agencé de telle sorte qu'à l'insertion de l'ensemble électronique sous-marin (8a) dans la cavité (28) l'actionneur vient en prise avec une surface de la cavité et l'élément de poussée est déplacé par rapport au châssis (11) pour déplacer le sous-ensemble électronique vers la position déployée.

9. Ensemble électronique sous-marin (3) selon la revendication 7 ou la revendication 8, dans lequel l'élément de poussée comprend une broche à ressort (31a, 31b) faisant saillie à partir de l'élément de poussée et agencée pour venir en prise avec la surface de la cavité (28).

10. Ensemble électronique sous-marin (3) selon l'une quelconque des revendications 7 à 9, dans lequel le châssis (11) comprend un second élément de poussée (27) ayant une surface inclinée agencée en alignement, parallèlement à la surface inclinée de l'élément de poussée et disposée sur une extrémité opposée du sous-ensemble électronique (8a).

11. Ensemble électronique sous-marin (3) selon l'une quelconque des revendications 7 à 10, dans lequel le châssis (11) comprend un second élément de poussée (27) ayant une surface inclinée agencée de manière opposée à la surface inclinée de l'élément de poussée et disposée sur un côté opposé du sous-ensemble électronique (8a).

12. Ensemble électronique sous-marin (3) selon l'une quelconque revendication précédente, comprenant un second sous-ensemble électronique (8b) monté de manière déplaçable sur le châssis (11) et déplaçable entre une position rétractée pour l'insertion de l'ensemble électronique sous-marin dans la cavité (28) du boîtier (20), et une position déployée où le second sous-ensemble électronique (8b) est déplacé à l'écart du châssis pour entrer en contact avec une surface de la cavité du boîtier pendant l'utilisation et, éventuellement,
dans lequel le second sous-ensemble électronique (8b) est monté sur un côté opposé du châssis (11) au sous-ensemble électronique (8a), et/ou
dans lequel chacun des premier et second sous-ensembles électroniques (8a, 8b) comprend une PCB, chaque PCB comprenant une même forme et une même disposition d'acheminement.

13. Ensemble électronique sous-marin selon l'une quelconque revendication précédente, dans lequel l'ensemble électronique sous-marin comprend une partie d'étanchéité de boîtier (5) et le ou les sous-ensembles électroniques sont reliés de manière flexible à la partie d'étanchéité de boîtier.

14. Module électronique sous-marin (1) comprenant l'ensemble électronique sous-marin (3) selon l'une quelconque revendication précédente, et un boîtier (20) ayant une cavité (28) adaptée pour recevoir l'ensemble électronique sous-marin et, éventuellement,
dans lequel le boîtier (20) est allongé et la cavité (28) comprend une paroi latérale, une extrémité fermée (29), et une extrémité ouverte (34), et dans lequel dans la position déployée le sous-ensemble électronique (8a) est en contact avec la paroi latérale.

15. Module électronique sous-marin selon la revendication 14, dans lequel le boîtier (20) comprend un actionneur (12) conçu pour déplacer le sous-ensemble électronique (8a) jusque dans la position déployée à l'insertion de l'ensemble électronique sous-marin (3) dans la cavité (28) et, éventuellement,
dans lequel l'actionneur (12) comprend un élément de poussée (25) ayant une surface inclinée adaptée pour pousser le sous-ensemble électronique à l'écart (3) du châssis (11) et vers la position déployée à mesure que l'ensemble électronique sous-marin est inséré dans la cavité (28).
